# EUROPEAN PATENT APPLICATION

(11) **EP 4 542 545 A1**
(43) Date of publication of application: **23.04.2025**
(21) Application number: 24204199.4
(22) Date of filing: 02.10.2024
(51) Int. Cl.: G10L 21/0316, H03G 3/32, G10L 25/78, G10L 25/84

(54) **SYSTEM AND METHOD FOR AUDIO LIMITING IN CALL DOWNLINK ALGORITHM**

(30) Priority: 17.10.2023 CN 202311347262
(71) Applicant: Harman International Industries, Inc., Stamford, Connecticut 06901 (US)
(72) Inventor: DUAN, Yuanru, Shenzhen, 518067 (CN); WANG, Yiyuan, Shenzhen, 518067 (CN); BAO, Hesheng, Shenzhen, 518067 (CN); TIAN, Chun, Shenzhen, 518067 (CN)
(74) Representative: Kraus & Lederer PartGmbB

(57) **Abstract**

A system for audio limiting in a call downlink algorithm during a call is provided, the audio limiter enables automatic amplification of the low pitch and suppression of the high pitch on the earphone side and prevents distortion of the high pitch, so that the audio limiter can ensure that an earphone wearer can clearly understand the voice content and maintain a consistent volume level regardless of whether the sound of a far-end speaker is small or large.

## Description

### Technical Field

The present inventive subject relates generally to audio processing, and particularly to a system and a method for audio limiting in a downlink algorithm.

### Background

Using earphones to make phone calls has become a common practice in daily life. However, when using an earphone for a call, a near-end earphone user is generally unable to control the behavior of a far-end user. For example, sometimes the far-end user may be too far away from the phone or microphone, so that it is difficult for the near-end earphone user to hear the other person clearly. Conversely, a person at the far end may suddenly speak loudly, which causes a sudden surge in the volume of the near-end earphone, resulting in a poor experience at the near-end earphone user side.

Therefore, in order to improve the call experience, an audio limiter device is required, which necessarily maintains a consistent volume for a near-end earphone user, no matter how soft or loud a far-end person speaks.

### Summary of the Invention

According to one aspect of the present inventive subject, a method for audio limiting in a call downlink is provided. The method includes receiving far-end sound from a far-end device through an audio limiting module configured at a near-end device, and performing voice activity detection and adjusting a current volume for each audio frame of a plurality of audio frames in the received far-end sound. The method further includes playing far-end sound with the adjusted volume through a speaker of the near-end device. The step of adjusting the current volume in the method further includes calculating a difference between the current volume and a target volume and regarding it as a gain, and applying the gain to a current audio frame.

According to another aspect of the present inventive subject, a system for audio limiting in a call downlink is provided. The system includes an audio limiting module, which is configured to receive far-end sound from a far-end device at a near-end device, and perform voice activity detection and adjust a current volume for each audio frame of a plurality of audio frames in the received far-end sound. The system further includes a speaker in the near-end device, and the speaker is configured to play far-end sound with the adjusted volume in the near-end device. Adjusting the current volume in the system further includes calculating a difference between the current volume and a target volume and regarding it as a gain, and applying the gain to a current audio frame.

The audio limiting system and method provided by the present inventive subject only play a role in the detected speech part, and can perform noise suppression on the non-speech part at the same time.

### Description of the Drawings

These and/or other features, aspects, and advantages of the present invention will be better understood upon reading the following detailed description with reference to the accompanying drawings, where the same characters represent the same components throughout these accompanying drawings:
FIG. 1 shows a schematic diagram of a system for audio limiting in a call downlink according to one or more embodiments of the present inventive subject;
FIG. 2A shows a step flow chart of a method for audio limiting in a call downlink according to one or more embodiments of the present inventive subject;
FIG. 2B shows an algorithm flow chart of a method for audio limiting in a call downlink according to one or more embodiments of the present inventive subject;
FIG. 3A shows a volume comparison before and after audio limiting is used in a call downlink according to one or more embodiments of the present inventive subject, wherein a far-end sound volume received by a near-end device before audio limiting is used is 49 dB;
FIG. 3B shows a volume comparison before and after audio limiting is used in a call downlink according to one or more embodiments of the present inventive subject, wherein a far-end sound volume received by a near-end device before audio limiting is used is 69 dB;
FIG. 3C shows a volume comparison before and after audio limiting is used in a call downlink according to one or more embodiments of the present inventive subject, wherein a far-end sound volume received by a near-end device before audio limiting is used is 89 dB; and
FIG. 3D shows a volume comparison before and after audio limiting is used in a call downlink according to one or more embodiments of the present inventive subject, wherein a far-end sound volume received by a near-end device before audio limiting is used is 99 dB.

### Detailed Description

Description of various embodiments is provided below for the purpose of illustration, but it is not intended to be exhaustive or to limit the disclosed embodiments. Many modifications and variations will be apparent to those of ordinary skill in the art without departing from the scope and spirit of the described embodiments.

In an existing call product, a user needs to control, through a button on the product (for example, on a mobile phone or an earphone), the volume of the other speaking person heard in a call. During a call, for example, the other person may whisper, which makes it difficult to hear. To hear clearly, the volume must be turned up by pressing the button. However, doing so will increase the background noise. Therefore, in order to improve the call experience during the speech call, no matter how soft or loud the voice of the person talking at the far end is, it is necessary to maintain a consistent volume for the user using the earphone at the near end.

In order to achieve this, the present inventive subject specifically introduces an audio limiter technique in a call downlink algorithm for the design of a near-end device, such as an earphone. In order to ensure that an earphone wearer can more comfortably hear far-end sound during a call, an audio limiting method is adopted in the downlink of the call algorithm to adaptively limit the audio. Here, the downlink refers to enabling the person at the near end to hear the voice of the other person at the far end, and the method for audio limiting provided by the present inventive subject only acts on the detected speech part. The speech part is processed differently according to the volume, the volume higher than a target volume is suppressed, and the volume lower than the target volume is increased. If the speech volume is too small, an upper threshold for the gain can limit the maximum gain, and avoid the background noise of the speech segment being excessively amplified, thereby improving the user experience. In this way, the caller can free his/her hands and the earphone can adaptively keep the listening volume at an appropriate level. At the same time, it can also suppress noise when there is no speech transmission (that is, no speech is detected).

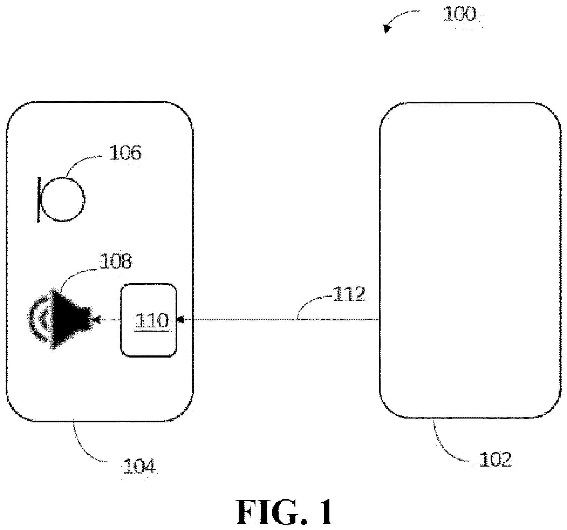

FIG. 1 shows a schematic diagram 100 of a system for audio limiting in a call downlink according to one or more embodiments of the present inventive subject. As shown in FIG. 1, a far-end device 102 may be, for example, a mobile phone or a telephone, and a near-end device 104 may be connected to the far-end device 102 in a wireless manner. For example, the near-end device 104 is an earphone, such as a headphone including a microphone 106 and a speaker 108. In one example, the headphone may include, but is not limited to, a Bluetooth headset. As can be seen from FIG. 1, a module 110 for audio limiting is added to the last portion of the downlink, and the module can be used to adaptively adjust the volume of the far-end sound 112 to a target volume, regardless of whether the far-end volume is large or small. Thus, the voice of the other person heard by the earphone user at the near end can be controlled to keep at the target volume level.

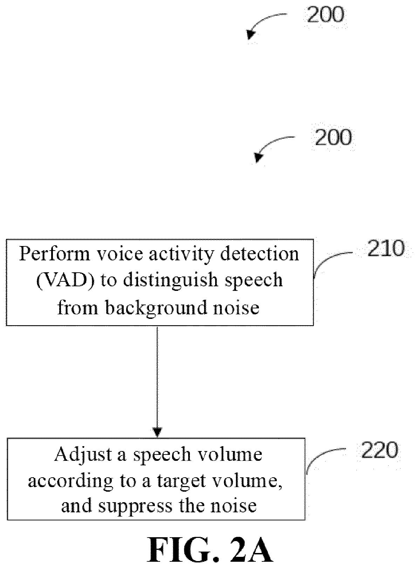

FIG. 2A shows a step 200 of a method for audio limiting in a call downlink according to one or more embodiments of the present inventive subject. The method for audio limiting in a call downlink audio limiter is mainly divided into two parts: voice activity detection (VAD) and applying a gain to adjust the volume. As shown in FIG. 2A, the near-end device first performs voice activity detection in step S210 after receiving sound from the far-end device, for distinguishing between a speech segment and a pure noise segment contained in received voice segments in an earphone. In the near-end earphone, it only intends to adjust the volume when there is a speech, and therefore, the speech segment is first distinguished from the pure noise segment. Then, in step S220, the volume of the speech heard can be adjusted according to the target volume by the distinguishing result of the voice activity detection. Noise can be suppressed when there is no speech. The volume-adjusted speech can be delivered to the user through a speaker in the near-end device.

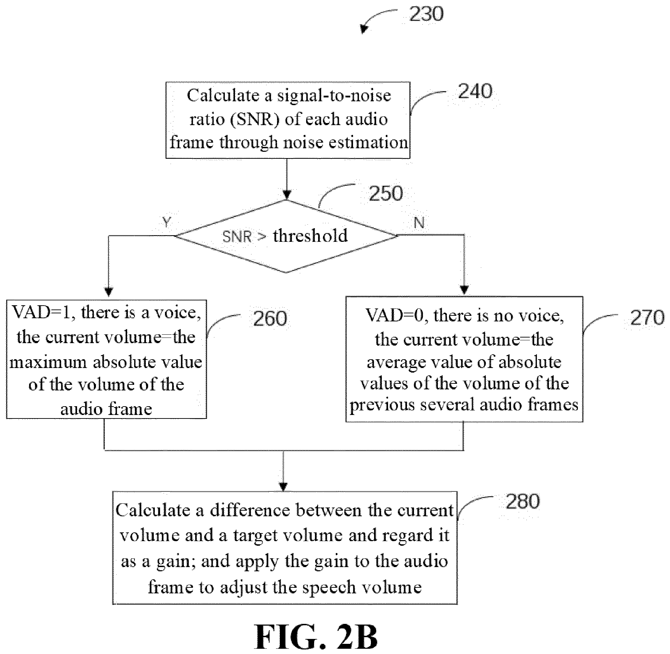

FIG. 2B shows an algorithm flow chart 230 of a method for audio limiting in a call downlink according to one or more embodiments of the present inventive subject. Here, the downlink means that the near-end device receives audio data, that is, the audio data is transmitted from the far-end device to the near-end device. It will be appreciate by those skilled in the art that before reaching the audio limiter, the downlink audio data is decoded by an audio decoder to obtain an audio digital signal ready for processing, and that the processing process into the audio limiter module is performed in a time-frequency domain.

Referring to FIG. 2B, in an example of a downlink call audio limiting algorithm, first, in the audio limiter, as described in a block 240, a signal-to-noise ratio (*SNR*) for each audio frame is calculated by noise estimation for a segment of speech received by the earphone. Then, it is determined whether the audio frame has voice, as shown in a block 250, wherein when the *SNR* exceeds a predetermined threshold (Y), it is determined that the frame has voice, and when the SNR does not reach the threshold level (N), the frame is determined to be noise. For example, if the SNR exceeds a predetermined threshold *Thres _v,* it is determined that there is voice in the frame, that is, *VAD_T* = 1. Conversely, if the SNR does not exceed the predetermined threshold *Thres_v*, it is determined that there is no voice in the frame, or that the frame should be silent, that is, *VAD_T =* 0. The determination of the *SNR* threshold can be obtained through acoustic data actually collected by simulation in an implementation process of a specific project. In one example, the predetermine threshold is, for example, 15 dB. It should be noted that for the setting of the SNR threshold, the voice should be not determined as noise as much as possible, thereby avoiding effective voice from being incorrectly amplified or compressed.

Then, a current volume is obtained. When the determination result of the current frame is *VAD_T =* 1, that is, there is voice, the current volume is acquired as a maximum absolute value of the audio frame volume in a block 260. Specifically, the volume of the frame takes the maximum amplitude of all audio samples in the frame. For example, a speech sampling rate is 16 kHz, and the number of sampling bits is 16 bits. Each audio frame selects an audio length of 16 ms for processing, corresponding to 256 sampling points, and selects the maximum value among amplitudes of the 256 samples as the current volume of the frame.

In addition, when the determination result of the current frame is *VAD_T =* 0, that is, there is no voice, in a block 270, the current volume is acquired as an average value of maximum absolute values of the volume of several speech presence frames before the audio frame. For example, the average value of the maximum absolute values of amplitudes obtained per frame for several previous speech presence frames saved in a buffer is regarded as the current volume. For example, the average value of the maximum absolute values of amplitudes obtained per frame for 128 speech presence frames saved in the buffer is regarded as the current volume.

Next, a gain of adjusting the current volume to the target volume is calculated. The value of the target volume may be experience-based, which may be an adjustable range of target values. For each frame, a difference between the current volume and the target volume may be calculated. The difference is regarded as the gain to adjust the current volume to the target volume. The gain should be limited in a certain range, for example, in a range having an upper threshold and a lower threshold. For example, it should be ensured that the voice heard can be prevented from being amplified too much. At the same time, the gain value can further be smoothed. For example, the gain is smoothed sample by sample in the frame range, so as to prevent the excessive fluctuation of the gain value from introducing abnormal noise.

Then, after the above smoothing process, the volume difference is compensated in the near-end earphone sample by sample in the frame.

As can be seen, in order to avoid processing noise or silence fragments, the VAD (voice activity detection) is necessary. If the noise is also amplified, it will affect the sensation of hearing. Preprocessing, such as smoothing, of the gain used to adjust the volume is also necessary. Therefore, the algorithm of the audio limiter may be as follows:

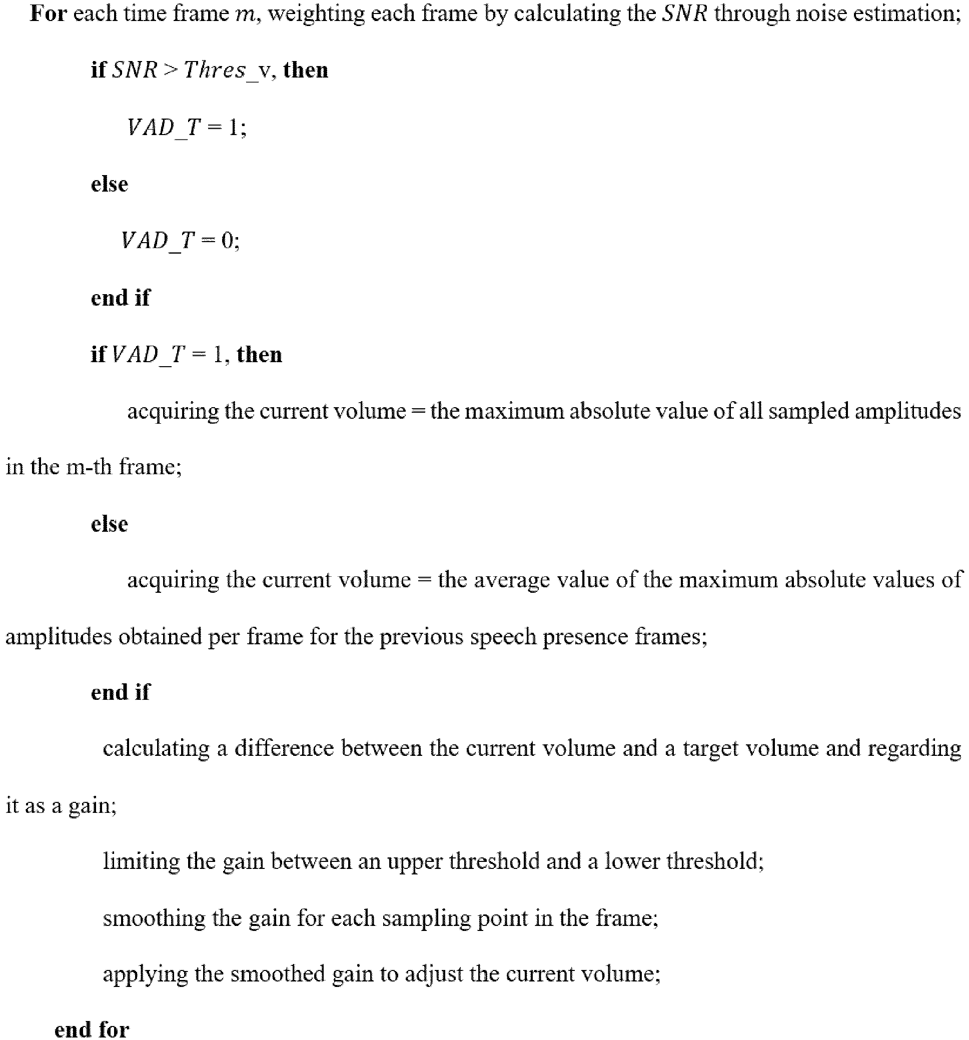

As mentioned above, the audio limiting system and method provided by the present inventive subject take different processing strategies according to whether a speech is detected or not, amplify or compress the speech to the target volume according to the current speech amplitude when the speech is detected, and suppress the detected pure noise segment. If the speech volume is too small, the upper threshold for the gain can limit the maximum gain, and avoid the background noise of the speech segment from being excessively amplified, thereby improving the user experience.

The audio limiter is used for the call downlink algorithm of the earphone to automatically amplify the low pitch, limit the high pitch and prevent the distortion of the high pitch.

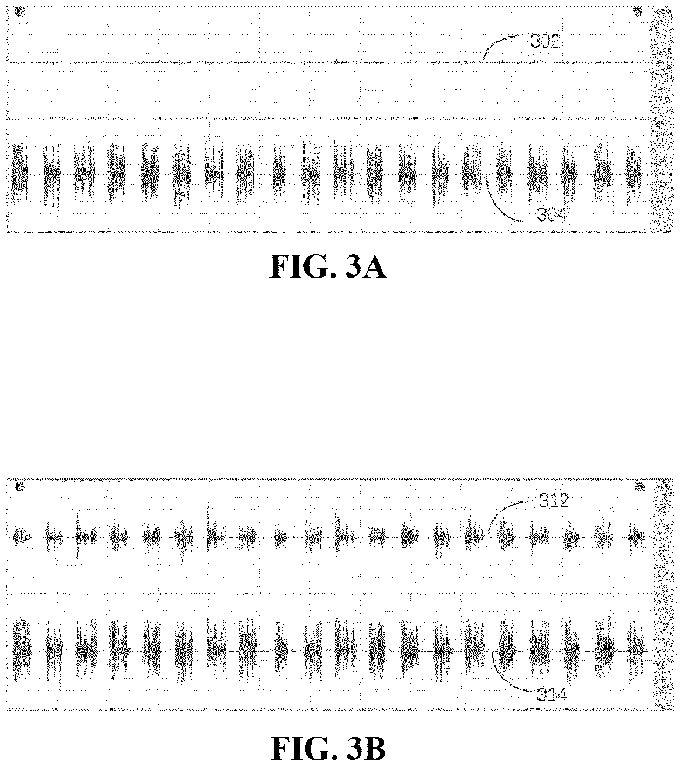

FIG. 3A to FIG. 3D show volume comparisons before and after audio limiting is used in a call downlink according to one or more embodiments of the present inventive subject. In a specific environment, an earphone connected to a mobile phone through a Bluetooth connection is regarded as the near end. The far end is a mobile phone, and the sound played by a human mouth is collected by the far-end mobile phone and transmitted to the near-end mobile phone through a communication link, and the human mouth is 0.2 m away from the mobile phone. In the example shown in FIG. 1, the near-end device 104 is an earphone and the far-end device 102 is a mobile phone. The volume of the far-end sound 112 is between 49 dB and 99 dB (measured at the human mouth). The volume after the audio limiter system is added to the downlink is adjusted to a stable volume. Amplitudes of a first channel (upper waveform) and a second channel (lower waveform) in each of the graphs in FIG. 3A to FIG. 3D represent volume levels before and after downlink processing with an audio limiter, respectively.

Specifically, in FIG. 3A, the waveform of the upper first channel represents that the volume of a far-end sound 302 from the far end is 49 dB, and after a gain is applied through the audio limiter, the lower second channel waveform represents that the volume of the voice that can be heard through the near-end earphone after the limiting is amplified (positive gain) to maintain the target volume of a sound 304 normally heard by the earphone.

In FIG. 3B, the waveform of the upper first channel represents that the volume of a far-end sound 312 from the far end is 69 dB, and after a gain is applied through the audio limiter, the lower second channel waveform represents that the volume of the voice that can be heard through the near-end earphone after the limiting is amplified (positive gain) to maintain the target volume of a sound 314 normally heard by the earphone.

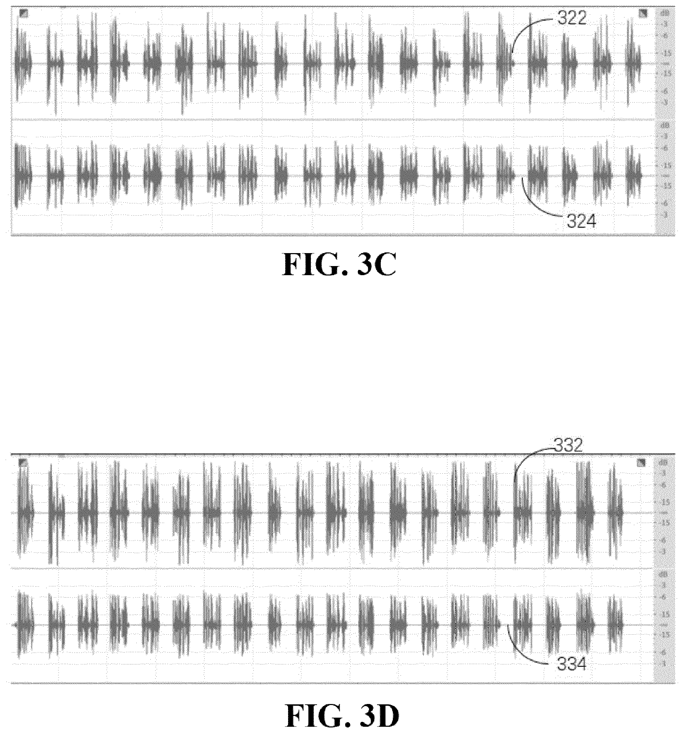

Similarly, in FIG. 3C, the waveform of the upper first channel represents that the volume of a far-end sound 322 from the far end is 89 dB, and after a gain is applied through the audio limiter, the lower second channel waveform represents that the volume of the voice that can be heard through the near-end earphone after the limiting is amplified (negative gain) to maintain the target volume of a sound 324 normally heard by the earphone.

Moreover, in FIG. 3D, the waveform of the upper first channel represents that the volume of a far-end sound 332 from the far end is 99 dB, and after a gain is applied through the audio limiter, the lower second channel waveform represents that the volume of the voice that can be heard through the near-end earphone after the limiting is amplified (negative gain) to maintain the target volume of a sound 334 normally heard by the earphone.

As can be seen by comparing FIG. 3A to FIG. 3D above, the target volume is set to be the same, and therefore, in the case of the four far-end sounds, the volume of the voice in the far-end sound heard by the near-end earphone user from the earphone has been processed by the audio limiter to be at the target volume level, while the background noise at the speech interval segments of each picture is suppressed and not incorrectly amplified. As a result, the earphone user is able to hear a clear, volume-appropriate voice.

The audio limiter is used in a call downlink algorithm for earphones to automatically amplify the low pitch, limit the high pitch, and prevent distortion of the high pitch. For example, by adjusting each frequency point, clipping of the amplitude can be avoided, thereby preventing cracking voice. This method is more like volume control, which always keeps the speech volume at a target level. In this way, the earphone user can listen at a stable volume. In this process, according to the distinguishing result of the voice activity detection, the volume is adjusted only when there is a speech, and the noise is suppressed when there is no speech.

Examples of one or more embodiments of the present inventive subject are described in the following clauses:
Clause 1. A method for audio limiting in a call downlink, including:
   receiving far-end sound from a far-end device through an audio limiting module at a near-end device;
   performing voice activity detection and adjusting a current volume for each audio frame of a plurality of audio frames in the received far-end sound; and
   playing far-end sound with the adjusted volume through a speaker of the near-end device,
   wherein the adjusting a current volume includes:
      calculating a difference between the current volume and a target volume and regarding it as a gain; and
      applying the gain to a current audio frame.
Clause 2. The method according to clause 1, wherein the performing voice activity detection includes:
   calculating a signal-to-noise ratio of the each audio frame of the plurality of audio frames in the received far-end sound through noise estimation;
   determining the current audio frame as an audio frame containing a speech when the signal-to-noise ratio is higher than a predetermined threshold; and
   determining the current audio frame as an audio frame not containing a speech when the signal-to-noise ratio is not higher than the predetermined threshold.
Clause 3. The method according to clause 1 or clause 2, wherein the adjusting a current volume further includes:
   for the current audio frame being an audio frame containing a speech, taking the current volume as a maximum absolute value among amplitudes of all sampled samples in the current audio frame.
Clause 4. The method according to any one of clause 1 to clause 3, wherein the adjusting a current volume further includes:
   for the current audio frame being an audio frame not containing a speech, taking the current volume as an average value of maximum absolute values of amplitudes obtained per frame for the previous several audio frames containing a speech.
Clause 5. The method according to any one of clause 1 to clause 4, wherein applying the gain to the current audio frame further includes:
   previously limiting the gain to a range between an upper threshold and a lower threshold, and smoothing the gain sample by sample during the current audio frame.
Clause 6. The method according to any one of clause 1 to clause 5, wherein the target volume is a value taken based on experience.
Clause 7. The method according to any one of clause 1 to clause 6, wherein the near-end device is an earphone, the far-end device is a mobile phone, and the near-end device is connected to the far-end device via a Bluetooth connection.
Clause 8. A system for audio limiting in a call downlink, including:
   an audio limiting module configured to receive far-end sound from a far-end device at a near-end device, and perform voice activity detection and adjust a current volume for each audio frame of a plurality of audio frames in the received far-end sound;
   a speaker configured to play far-end sound with the adjusted volume in the near-end device,
   wherein the adjusting a current volume includes:
      calculating a difference between the current volume and a target volume and regarding it as a gain; and
      applying the gain to a current audio frame.
Clause 9. The system according to clause 8, wherein the performing voice activity detection includes:
   calculating a signal-to-noise ratio of the each audio frame of the plurality of audio frames in the received far-end sound through noise estimation;
   determining the current audio frame as an audio frame containing a speech when the signal-to-noise ratio is higher than a predetermined threshold; and
   determining the current audio frame as an audio frame not containing a speech when the signal-to-noise ratio is not higher than the predetermined threshold.
Clause 10. The system according to clause 8 or clause 9, wherein the adjusting a current volume further includes:
   for the current audio frame being an audio frame containing a speech, taking the current volume as a maximum absolute value among amplitudes of all sampled samples in the current audio frame.
Clause 11. The system according to any one of clause 8 to clause 10, wherein the adjusting a current volume further includes:
   for the current audio frame being an audio frame not containing a speech, taking the current volume as an average value of maximum absolute values of amplitudes obtained per frame for the previous several audio frames containing a speech.
Clause 12. The system according to any one of clause 8 to clause 11, wherein applying the gain to the current audio frame further includes:
   previously limiting the gain to a range between an upper threshold and a lower threshold, and smoothing the gain sample by sample during the current audio frame.
Clause 13. The system according to any one of clause 8 to clause 12, wherein the target volume is a value taken based on experience.
Clause 14. The system according to any one of clause 8 to clause 15, wherein the near-end device is an earphone, the far-end device is a mobile phone, and the near-end device is connected to the far-end device via a Bluetooth connection.
Clause 15. A non-temporary computer-readable medium storing instructions thereon, wherein the instructions, when executed by one or more processors, cause the one or more processors to perform the method for audio limiting in a call downlink according to clauses 1 to 7.

The elements of various real-time solutions for implementing the modules, elements, and components of the methods provided in the present inventive subject may be fabricated as one or more electronic devices residing on the same chip or in a chipset, including but not limited to an array of fixed or programmable logic elements (such as transistors or gates). One or more elements of various implementations of the device described herein may also be fully or partially implemented as one or more instruction sets, which may be arranged to execute on one or more fixed or programmable logic element arrays (such as microprocessors, embedded processors, IP cores, digital signal processors, FPGAs, ASSPs, and ASICs).

The selection of terms used herein is intended to best explain the principles and practical applications of the embodiments or the improvements to technologies found in the market, or to enable other persons of ordinary skill in the art to understand the embodiments disclosed herein.

In the above, reference is made to the embodiments presented in the present disclosure. However, the scope of the present disclosure is not limited to the specifically described embodiments. Rather, any combination of the above features and elements, whether related to different embodiments or not, is contemplated as implementing and practicing the contemplated embodiments.

Furthermore, although the embodiments disclosed herein can achieve advantages better than other possible solutions or better than the prior art, whether a given embodiment achieves specific advantages does not limit the scope of the present disclosure. Therefore, the above aspects, features, embodiments and advantages are merely illustrative and are not considered as elements or limitations of the appended claims unless explicitly recited in the claims.

Although the above content is directed to the embodiments of the present disclosure, other and further embodiments of the present disclosure can be designed without departing from the basic scope of the present disclosure, and the scope of the present disclosure is determined by the appended claims.

## Claims

1. A method for audio limiting in a call downlink, comprising:
receiving far-end sound from a far-end device through an audio limiting module at a near-end device;
performing voice activity detection and adjusting a current volume for each audio frame of a plurality of audio frames in the received far-end sound; and
playing far-end sound with the adjusted volume through a speaker of the near-end device,
wherein the adjusting a current volume comprises:
calculating a difference between the current volume and a target volume and regarding it as a gain; and
applying the gain to a current audio frame.

2. The method according to claim 1, wherein the performing voice activity detection comprises:
calculating a signal-to-noise ratio of the each audio frame of the plurality of audio frames in the received far-end sound through noise estimation;
determining the current audio frame as an audio frame containing a speech when the signal-to-noise ratio is higher than a predetermined threshold; and
determining the current audio frame as an audio frame not containing a speech when the signal-to-noise ratio is not higher than the predetermined threshold.

3. The method according to claim 2, wherein the adjusting a current volume further comprises:
for the current audio frame being an audio frame containing a speech, taking a value of the current volume as a maximum absolute value among amplitudes of all sampled samples in the current audio frame.

4. The method according to claim 2 or 3, wherein the adjusting a current volume further comprises:
for the current audio frame being an audio frame not containing a speech, taking a value of the current volume as an average value of maximum absolute values of amplitudes obtained per frame for the previous several audio frames containing a speech.

5. The method according to any preceding claim, wherein applying the gain to the current audio frame further comprises:
previously limiting the gain to a range between an upper threshold and a lower threshold, and smoothing the gain sample by sample during the current audio frame.

6. The method according to any preceding claim, wherein the target volume is a value taken based on experience.

7. The method according to any preceding claim, wherein the near-end device is an earphone, the far-end device is a mobile phone, and the near-end device is connected to the far-end device via a Bluetooth connection.

8. A system for audio limiting in a call downlink, comprising:
an audio limiting module configured to receive far-end sound from a far-end device at a near-end device, and perform voice activity detection and adjust a current volume for each audio frame of a plurality of audio frames in the received far-end sound;
a speaker configured to play far-end sound with the adjusted volume in the near-end device,
wherein the adjusting a current volume comprises:
calculating a difference between the current volume and a target volume and regarding it as a gain; and
applying the gain to a current audio frame.

9. The system according to claim 8, wherein the performing voice activity detection comprises:
calculating a signal-to-noise ratio of each audio frame in the received far-end sound through noise estimation;
determining the current audio frame as an audio frame containing a speech when the signal-to-noise ratio is higher than a predetermined threshold; and
determining the current audio frame as an audio frame not containing a speech when the signal-to-noise ratio is not higher than the predetermined threshold.

10. The system according to claim 9, wherein the adjusting a current volume further comprises:
for the current audio frame being an audio frame containing a speech, taking the current volume as a maximum absolute value among amplitudes of all sampled samples in the current audio frame.

11. The system according to claim 9 or 10, wherein the adjusting a current volume further comprises:
for the current audio frame being an audio frame not containing a speech, taking the current volume as an average value of maximum absolute values of amplitudes obtained per frame for the previous several audio frames containing a speech.

12. The system according to any of claims 8 to 11, wherein applying the gain to the current audio frame further comprises:
previously limiting the gain to a range between an upper threshold and a lower threshold, and smoothing the gain sample by sample during the current audio frame.

13. The system according to any of claims 8 to 12, wherein the target volume is a value taken based on experience.

14. The system according to any of claims 8 to 13, wherein the near-end device is an earphone, the far-end device is a mobile phone, and the near-end device is connected to the far-end device via a Bluetooth connection.

15. A non-temporary computer-readable medium storing instructions thereon, wherein the instructions, when executed by one or more processors, cause the one or more processors to perform the method for audio limiting in a call downlink according to claims 1 to 7.
